# EUROPEAN PATENT SPECIFICATION

(11) **EP 2 116 854 B1**
(45) Date of publication and mention of the grant of the patent: **12.01.2011**
(21) Application number: 08008650.7
(22) Date of filing: 08.05.2008
(51) Int. Cl.: G01R 15/18, G01R 15/22, G01R 21/06

(54) **Active current sensor and current measuring device**
Aktiver Stromsensor und Strommessvorrichtung
Capteur de courant actif et dispositif de mesure du courant

(43) Date of publication of application: 11.11.2009
(73) Proprietor: Areva T&D Messwandler GmbH, 19288 Ludwigslust (DE)
(72) Inventor: Jenau, Frank, Dr., 22399 Hamburg (DE)
(74) Representative: Schäfer, Wolfgang

(56) References cited:
- EP-A- 0 288 998
- WO-A-99/42844
- US-A- 4 070 572
- US-A- 4 158 810
- US-A- 4 796 148
- US-A1- 2005 253 573
- ZHANG GANG ET AL: "A Novel Electro-Optic Hybrid Current Measurement Instrument for High-Voltage Power Lines" IEEE TRANSACTIONS ON INSTRUMENTATION AND MEASUREMENT, IEEE SERVICE CENTER, PISCATAWAY, NJ, US, vol. 50, no. 1, 1 February 2001 (2001-02-01), XP011025148 ISSN: 0018-9456

## Description

The present invention refers to an active current sensor for a current measuring device to measure a current at a high voltage direct current line, wherein the current sensor comprises a power supply arrangement to power the current sensor. The present invention further refers to a current measuring device for a high voltage direct current line comprising a current sensor and a data receiver arrangement coupled with each other.

An arrangement for measurement of a voltage or a current in high voltage equipment is disclosed in DE 28 29 949 A1. The arrangement described therein uses sunlight or artificial light and energy of harmonic oscillations of magnetic field of a high voltage line to charge a battery of the measurement arrangement.

EP-A-0288998 discloses a self-powered measuring system isolated from electrical perturbances in which a floating supply circuit comprising a tapping coil having a magnetic core disposed around the conductor is provided to produce the supply voltage for the measuring system.

The object of the present invention is to provide an active current sensor for a current measuring device for a direct current high voltage line, which is reliable and can be simply and inexpensively manufactured.

According to the present invention, this object is achieved by an active current sensor of the above mentioned kind that is **characterized in that** the power supply arrangement comprises first power supply circuitry that have an air-core coil exposed to a magnetic field originating from the current at the high voltage line, wherein the first power supply circuitry is arranged to power the current sensor at least partly by means of a voltage induced in the air-core coil by the magnetic field.

Using an air-core coil to bypass power from the high voltage line to the active current sensors via the first power supply circuitry of the current sensor leads to a current sensor the power supply of which works efficiently and reliably. Air-core coils are coils a core of which is made of non-ferromagnetic material. Although air-core coils can be realized by omitting the core completely, for sake of mechanical stability, they usually have a magnetically inactive core.

According to the present invention, it has been realized that an air-core coil is especially well-suited to extract power from the magnetic field originating from a direct current line (DC line). Due to the lack of a ferromagnetic core the direct current, which has no fundamental oscillation, cannot drive the coil into saturation. Therefore, superimposed harmonic oscillations of the direct current (also referred to as an AC component of the direct current) induce a rather high voltage in the coil even if an amplitude of the harmonic oscillations is small compared to a mean voltage at the DC line. This voltage induced by the AC component superimposed on the direct current can be used to power the active current sensor.

The harmonic oscillations of the direct current are typically introduced to the high voltage line by an AC to DC converter that serves as a voltage supply source and that is connected to the high voltage line. These harmonic oscillations normally being undesired are called parasitic harmonics. The current sensor according to the present invention uses these parasitic harmonics as a power source.

According to a preferred embodiment of the present invention the air-core coil is a Rogowski coil. Although the Rogowski coil is normally used to measure alternating currents (AC) it has been shown that it also can be advantageously used to obtain the power of the parasitic harmonics of the magnetic field of the direct current flowing through the high voltage line. Because the Rogowski coil is a standard component used in high voltage systems the current sensor can be inexpensively manufactured.

In an embodiment of the present invention, the first power supply circuitry comprises a rectifier to rectify the voltage induced in the coil and/or the first power supply circuitry comprises a voltage stabilizer to stabilize the voltage induced in the coil. Here, the voltage stabilizer may comprise a voltage regulator, such as a linear regulator or a switching regulator.

In a preferred embodiment of the present invention, the power supply arrangement comprises second power supply circuitry that can be connected to an external power source to power the current sensor. According to this embodiment, the power supply arrangement uses two power sources, namely the magnetic field of the high voltage line and the external power source. Thus, the actual power output of a single power source is only a part of the overall power consumption of the current sensor. Hence, low-power and therefore comparatively simple and inexpensive power sources can be applied. For example, the external power source can be designed for such a low output power that passive cooling of the external power source is sufficient. This allows for a simple external power source with a high durability.

Furthermore, an embodiment is suggested, wherein the external power source is a light source and the second power supply arrangement comprises an optical power converter to convert light radiation emitted by the light source into electrical power. Preferably, the light source is a laser or a high power laser. Because light is used to transport power from the external power source, i.e. the laser, to the current sensor the external power source and the current sensor can reside on different electrical potentials. For example, the current sensor can reside on a high potential of the high voltage line and the external power source can reside on a ground potential. As the laser has to provide only a part of the power needed by the current sensor the laser can be operated at a comparatively low power level. Thus, the laser has a good durability and rather low power dissipation. Preferably, a light guide such as an optical fibre is used to transmit the light from the external power source to the current sensor.

It is further suggested, that the current sensor comprises a shunt inserted in the high voltage line such that the current at the high voltage line leads to a voltage drop at the shunt, wherein an amount of the voltage drop corresponds to the current at the high voltage line. A current sensor comprising a shunt to measure the current can be cost-efficiently realized even for voltages higher than 400 kV.

According to a preferred embodiment of the present invention, the current sensor comprises a data transmission arrangement for transmission of data representing a value of the current acquired by the current sensor. By data transmission the data representing the value of the current can be transferred to a place away from the high voltage line, wherein that place is preferably at least essentially at ground potential.

Preferably, the data transmission arrangement comprises an optical transmitter to transmit the data representing the value of the current at the high voltage line. An optical transmission system provides both fast and reliable data transmission as well as potential separation of the potential on which the current sensor resides and the potential of a data receiver that is arranged to receive the data transmitted by the data transmitter. The data receiver preferably resides at least essentially on ground potential.

The object of the present invention is also solved by a current measuring device for a high voltage direct current line comprising a current sensor and a data receiver arrangement coupled with each other, that is characterized in that the current measuring device is a current sensor according to the present invention. The current measuring device according to the invention has the advantages of the above described current sensor.

In a preferred embodiment of the current measuring device, the current measuring device has a light source, preferably comprising a laser, and the light source is coupled with the optical power converter of the current sensor. The laser is preferably a high power laser. That is, the laser provides a power source for the current sensor. When the current sensor is operating the laser lights the optical power converter of the current sensor and the optical power converter converts at least a part of the energy of the light emitted by the laser into electrical energy used to power the current sensor.

Preferably, the light source of the data receiver arrangement and the optical power converter of the current sensor are coupled by a first light guide and/or the optical receiver of the data receiver arrangement and the optical transmitter of the current sensor are coupled by a second light guide. When using light guides the current sensor and the data receiver arrangement can be easily located on different places. In addition, the light guides provide effective potential separation and/or electrical insulation between the current sensor, the data receiver arrangement, and the light source. Because the light source must provide a part of the power needed to operate the current sensor only loss within the light guide is relatively uncritical. Hence, comparatively long light guides, which have a rather high loss, can be applied.

In another embodiment, the light source of the data receiver arrangement and the optical power converter of the current sensor as well as an optical receiver of the data receiver arrangement and the optical transmitter of the current sensor are coupled by a single light guide.

In order to ease installation of the current measuring device it is suggested that the first light guide, the second light guide, and/or the single light guide is an optical fibre. The usage of a light guide allows for a flexible installation of the various components of the current sensor.

It is further suggested that the data receiver arrangement is connected to the light source to control an output power of the light source depending on the optical power needed by the optical power converter to operate the current sensor. By this means, a control loop is provided which increases the output power of the light source if the second power supply circuitry must provide more power to operate the current sensor. This might be the case if a strength of the current at the high voltage line is comparatively low and the first power supply circuitry can provide only a comparatively small portion of the power needed to operate the current sensor. If the current at the high voltage line is relatively high then the first power supply circuitry can provide a rather high portion of the power needed to operate the current sensor so that the control loop can decrease the output power of the light source.

A preferred embodiment and further advantages of the present inventions are shown in the figures and described in detail hereinafter.
- Fig. 1: shows a high voltage direct current (HVDC) power transmission system comprising a direct current (DC) line and a current measuring device connected to the DC line; and
- Fig. 2: shows a light source and a data receiver arrangement of the current measuring device in more detail.

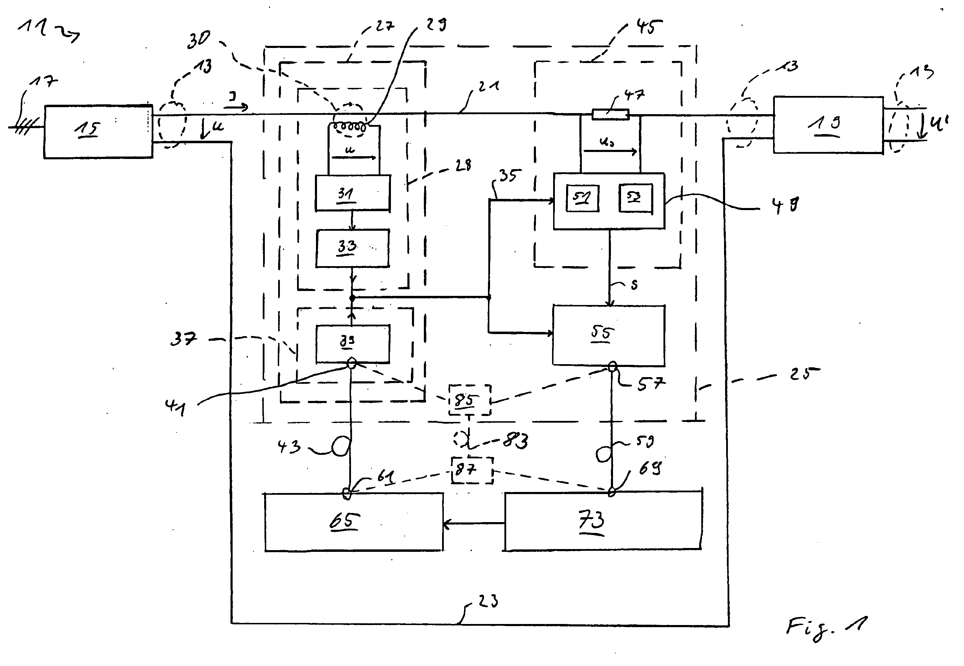

In Fig. 1, a HVDC transmission system 11 is shown in its entirety. The system 11 comprises a high voltage DC line 13. One end of the DC line 13 is connected to an output of an alternating current to direct current converter 15 (AC to DC converter 15). An input of the AC to DC converter 15 is connected to a three-phase alternating current line 17 (AC line 17). In a not shown embodiment of the present invention, the AC to DC converter 15 is connected to a single-phase AC line. Another end of the DC line 13 is connected to an input of a filter bank 19. An output of the filter bank 19 may be connected to a load (not shown).

The DC line 13 consists of a first conductor 21 and a second conductor 23. In an embodiment, one of the conductors 21, 23 may be any kind of ground return means. As shown in the figure, a current sensor 25 is inserted in the DC line 13. The current sensor 25 comprises a power supply arrangement 27. First power supply circuitry 28 of that power supply arrangement 27 comprise an air-core coil 29 in the form of a Rogowski coil, a rectifier 31, an input of which is connected to the air-core coil 29, and a voltage stabilizer 33 an input of which is connected to an output of the rectifier 31. The air-core coil 29 is arranged around the first conductor 21 of the DC line 13 so that the air-core coil 29 is subjected to a magnetic field 30 generated by a current I flowing through the first conductor 21 of the DC line 13. An output of the voltage stabilizer 33 of the first power supply circuitry 28 is connected to an internal power supply line 35 of the current sensor 25.

The power supply arrangement 27 of the current sensor 25 further comprises second power supply circuitry 37. The second power supply circuitry 37 has an optical power converter 39 (OPC 39) and first connection means 41 to connect a first light guide 43 to the optical power converter 39. An output of the optical power converter 39 is connected to the internal power supply line 35.

Furthermore, the current sensor 25 comprises a current sensor element 45 which has a shunt 47 inserted in the first conductor 21 of the DC line 13 and signal processing means 49. The signal processing means 49 comprise signal filter means 51 as well as an analogue to digital converter 53 (ADC 53). The signal filter means 51 can include analogue filters, digital filters, or any combination thereof.

Although, in the shown embodiment, the current sensor element 45 comprises a shunt 47 the present invention can also be applied on current sensor elements 45, which use different means to acquire the current I at the first conductor 21. For example, a zero-flux magnetic current transformer can be used instead of the shunt 47.

An output of the signal processing means 49 is connected to an input of an optical transmitter 55 of the current sensor 25. The optical transmitter 55 has a second connection means 57 to connect a second light guide 59. Both the first light guide 43 and the second light guide 59 are optical fibres.

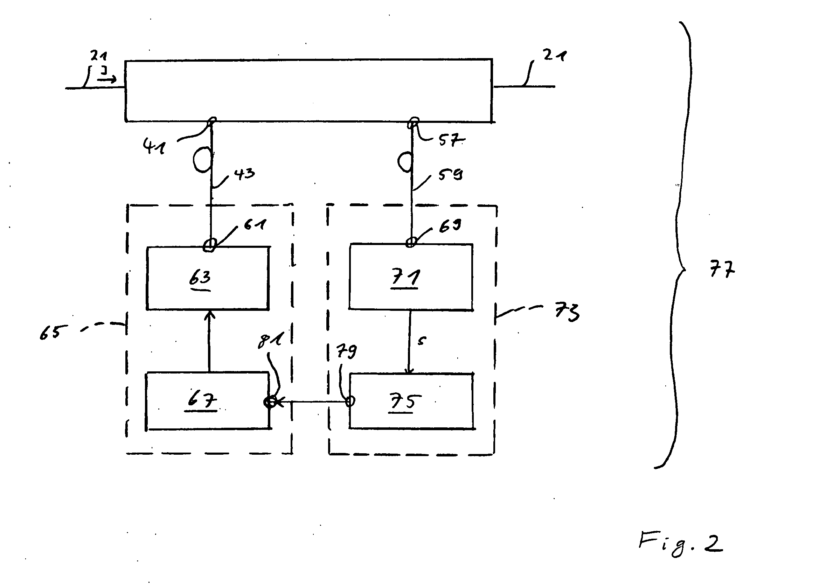

As shown in Fig. 2, one end of the first light guide 43 is connected to the first connection means 41 of the second power supply circuitry 37 whereas another end of the first light guide 43 is connected to third connection means 61 of a high power laser 63 of a light source 65. Besides the laser 63, the light source 65 comprises a laser power supply arrangement 67 connected to a low voltage electrical grid, which resides substantially on ground potential. An output of the laser power supply arrangement 67 is connected to the laser 63.

A first and a second end of the second light guide 59 are connected to the second connection means 57 of the optical transmitter 55 and fourth connection means 69 of an optical receiver 71 of a data receiver arrangement 73, respectively. The data receiver arrangement 73 comprises data processing and/or analysing means 75. An output of the optical receiver 71 is connected to an input of the data processing and/or analysing means 75. The data processing and/or analysing means 75 can be connected to control facilities or monitoring facilities to monitor and/or control the transmission system 11. To this end, a communication system such as a communication network and/or a bus system may be applied. The data processing and/or analysing means 75 may be equipped with a suitable data interface.

The current sensor 25, the light source 65, and the data receiver arrangement 73 are parts of a current measuring device 77. Other than in the shown embodiment, the light source 65 and the data receiver arrangement 73 can be combined to a single unit. As a consequence, the third connection means 61 and the fourth connection means 69 are located next to each other so that the two light guides 43 and 59 can be installed essentially in parallel.

As shown in Fig. 2, the data processing and/or analysing means 75 of the data receiver arrangement comprise a control output 79 connected to a control input 81 of the laser power supply arrangement 67 to form a control loop.

In another embodiment of the present invention, a single light guide 83, preferably a single optical fibre, is applied to connect the optical power converter 39 to the light source 65 and to connect the optical receiver 71 of the data receiver arrangement 73 to the optical transmitter 55. To this end, the current sensor 25 comprises first optical coupling means 85, which are connected to a first end of the single light guide 83, the first connection means 41 of the optical power converter 39, and the second connection means 57 of the optical transmitter 55. In addition, the current measuring device 77 comprises second optical coupling means 87, which are connected to a second end of the single light guide 83, the third connection means 61 of the light source 65, and the fourth connection means 69 of the data receiver arrangement 73. Both the first optical coupling means 85 as well as the second optical coupling means 87 may have at least one optical filter and/or at least one fibre coupler arranged to separate light of different wavelengths.

When operating the transmission system 11, an AC voltage is applied on the three-phase AC line 17. The AC to DC converter 15 converts the alternating current at the AC line 17 to a DC voltage U and applies the DC voltage U between the first conductor 21 and the second conductor 23 of the DC line 13. The DC voltage U is also connected to the filter bank 19 and accordingly to the load of the system 11. As a consequence, the current I is flowing trough the two conductors 21, 23 of the DC line 13.

Because the AC to DC converter 15 does not generate an ideal DC voltage the current I is superimposed by harmonic oscillations, i.e. parasitic harmonics generated by the AC to DC converter 15. Thus, the direct current I is not constant but comprises oscillations with an amplitude which is in the order of some percents of the DC current I. Due to these oscillations a voltage u is induced in the air-core coil 29. The rectifier 31 converts the voltage u into a DC voltage and the voltage stabilizer 33 provides a stabilized supply voltage which is available at the internal power supply line 35.

The filter bank 19 is attenuating the parasitic harmonics so that an output voltage U' available at the output of the filter bank 19 comprises less parasitic harmonics than the voltage U between the AC to DC converter 15 and the filter bank 19. In the shown HVDC transmission system 11, the air-core coil 29 of the current sensor 25 is arranged before the filter bank 19 with respect to a direction of power transmission within the DC line 19. Hence, the current I flowing through that section of the first conductor 21 around which the air core coil 29 is arranged comprises a comparatively high portion of the parasitic harmonics. As a consequence, an amplitude of the induced voltage u is comparatively high.

In addition, the optical power converter 39 of the second power supply circuitry provides electrical power for the power sensor 25 by converting the power of the light guided through the light guide 43 to electrical power. The light is generated by the laser 63 of the light source 65. That is, the light source 65 provides an external power source that is located at a different place than the current sensor 25. The laser power supply arrangement 67 provides the electrical power needed to operate the laser 63 and controls the output power of the laser 63, i.e., the power of the light emitted by the laser 63, depending on a control signal applied to the control input 81. To this end, the laser power supply arrangement 67 converts the voltage of an electrical line to which it is connected, e.g. the low voltage electrical power grid, to a voltage suitable to operate the laser 63.

Because the light source 65 needs to provide only a part of the power needed by the current sensor 25, the power output of the laser 63 is less than the power consumption of the current sensor 25. Thus, both the laser 63 and the laser power supply arrangement 67 have a low power dissipation. Therefore, an operation temperature of the laser 63 and the laser power supply arrangement 67 is below a critical limit although both parts 63, 67 may be passively cooled. The critical limit of the temperature of the parts of the light source 65 is typically about 55°C, which is sometimes, e.g., in tropical regions, close to an ambient temperature.

The electrical power provided by the two power supply circuitries 28, 37 of the power supply arrangement 27 is conducted to the current sensor element 45 and to the optical transmitter 55.

The current I at the first conductor 21 of the DC line 13 leads to a voltage drop U_{I} at the shunt 47. The signal filter means 51 filter the voltage drop U_{I} and the analogue to digital converter 53 generates a digital signal s, which comprises a value that characterises a strength of the current I. Depending on the exact realization of the signal processing means 49 the signal filter means 51 filter analogue signals and and/or digital signals.

The optical transmitter 51 converts the digital signal s to an optical signal, which is transmitted through the second light guide 59 and received by the optical receiver 71 of the data receiver arrangement 73. The optical receiver 71 regenerates the digital signal s and makes it available to the data processing and/or analysing means 75. Finally, the data processing and/or analysing means 75 transmit data representing the current I to control and/or monitoring facilities of the system 11.

The data processing and/or analysing means 75 determine an energy status which characterizes a discrepancy between the overall supply power available to the current sensor 25 and the power that is currently needed by the current sensor 25. To this end, the data processing and/or analysing means 75 may analyse a signal quality of the optical signal transmitted via the second light guide 59 (or the single light guide 83), e.g. data loss, signal-to-noise ratio, bit error rate and the like. The data processing and/or analysing means 75 output the control signal via the control output 79 and apply it to the control input 81 of the laser power supply arrangement 67. In order to provide a control loop to control the output power of the high power laser 63 depending on the power needed by the current sensor 25, the data processing and/or analysing means 75 generate the control signal depending on the determined energy status.

In the embodiment according to which the single light guide 83 is used the light generated by the laser 63 of the light source 65 has a different wavelength than the light generated by the optical transmitter 55, i.e., the laser 63 generates light of a first wavelength and the optical transmitter 55 generates light of a second wavelength. The first optical coupling means 85 feed the single light guide 83 with the light generated by the optical transmitter 55 and let pass the light of the first wavelength from the first end of the single light guide 83 to the optical power converter 39. Similarly, the second coupling means 87 feed the single light guide 83 with the light generated by the laser 63 of the light source 65 and let pass the light of the second wavelength from the second end of the single light guide 83 to the data processing and/or analysing means 75.

As shown in the figure the light source 65 and the data receiver arrangement 73 are not electrically connected to the current sensor 25. Typically, the light source 65 and the data receiver arrangement 73 reside at a ground potential whereas the current sensor 25 resides at the potential of the first conductor 21 of the DC line 13. The potential of the first conductor 21 of the DC line 21 is in the order of several hundred kV, typically more than 400 kV. The light guides 43 and 59 provide effective potential separation between the current sensor 25 and the remaining parts 65 and 73 of the current measuring device. Because the first light guide 43 transmits only a part of the power needed to operate the current sensor 25 the light source 65 can operate at a comparatively low power level and/or a rather high length of the first light guide 43 can be realized.

## Claims

1. Active current sensor (25) for a current measuring device (77) to measure a current (I) at a high voltage direct current line (13), wherein the current sensor (25) comprises a power supply arrangement (27) to power the current sensor (25), **characterised in that** the power supply arrangement (27) comprises first power supply circuitry (28) that have an air-core coil (29) exposed to a magnetic field (30) originating from the current (I) at the high voltage line (13), wherein the first power supply circuitry (28) is arranged to power the current sensor (25) at least partly by means of a voltage (u) induced in the air-core coil (29) by the magnetic field (30).

2. Current sensor (25) according to claim 1, **characterised in that** the air-core coil is a Rogowski coil (29).

3. Current sensor (25) according to claim 1 or 2, **characterised in that** the first power supply circuitry (28) comprises a rectifier (31) to rectify the voltage (u) induced in the air-core coil (29) and/or the first power supply circuitry (28) comprises a voltage stabiliser (33) to stabilize the voltage (u) induced in the coil.

4. Current sensor (25) according to one of the precedent claims, **characterised in that** the power supply arrangement (27) comprises second power supply circuitry (37) that can be connected to an external power source (65) to power the current sensor (25).

5. Current sensor (25) according to claim 4, **characterised in that** the external power source is a light source (61) and the second power supply arrangement (37) comprises an optical power converter (39) to convert light radiation emitted by the light source (61) into electrical power.

6. Current sensor (25) according to one of the preceding claims, **characterised in that** the current sensor (25) comprises a shunt (47) inserted in the high voltage line (13) such that the current (I) at the high voltage line leads to a voltage drop (u_{I}) at the shunt (47), wherein an amount of the voltage drop (u_{I}) corresponds to the current (I) at the high voltage line (13).

7. Current sensor (25) according to one of the preceding claims, **characterised in that** the current sensor (25) comprises a data transmission arrangement for transmission of data representing a value of the current acquired by the current sensor arrangement.

8. Current sensor according to claim 7, **characterised in that** the data transmission arrangement comprises an optical transmitter (55) to transmit the data representing the value of the current (I) at the high voltage line (13).

9. Current measuring device (77) for a high voltage direct current line (13) comprising a current sensor (25) and a data receiver arrangement (73) coupled with each other, **characterized in that** the current sensor (25) is a current sensor (25) according to one of the preceding claims.

10. Current measuring device (77) according to claim 9, **characterised in that** the current measuring device (77) has a light source (65), preferably comprising a laser (63), and **in that** the light source (65) is coupled to the optical power converter (39) of the current sensor element.

11. Current measuring device (77) according to claim 9 or 10, **characterised in that** the light source (65) of the data receiver arrangement (73) and the optical power converter (39) of the current sensor (25) are coupled by a first light guide (43) and/or an optical receiver (71) of the data receiver arrangement (73) and the optical transmitter (55) of the current sensor (25) are coupled by a second light guide (59).

12. Current measuring device (77) according to claim 9 or 10, **characterised in that** the light source (65) of the data receiver arrangement (73) and the optical power converter (39) of the current sensor (25) as well as an optical receiver (71) of the data receiver arrangement (73) and the optical transmitter (55) of the current sensor (25) are coupled by a single light guide (83).

13. Current measuring device according to claim 11, **characterised in that** the first light guide (43), the second light guide (59), and/or the single light guide (83) is an optical fibre.

14. Current measuring device (77) according to one of the claims 10 to 13, **characterised in that** the data receiver arrangement (73) is connected to the light source (65) to control an output power of the light source (65) depending on the optical power needed by the optical power converter (39) to operate the current sensor (25).

## Patentansprüche

1. Aktiver Stromsensor (25) für eine Strommessvorrichtung (77) zum Messen eines Stroms (I) an einer Hochspannungs-Gleichstromleitung (13), wobei der Stromsensor (25) eine Energieversorgungsanordnung (27) zum Speisen des Stromsensors (25) aufweist, **dadurch gekennzeichnet, dass** die Energieversorgungsanordnung (27) eine erste Energieversorgungsschaltung (28) aufweist, die eine Luftkernspule (29) besitzt, die einem von dem Strom (I) an der Hochspannungsleitung (13) hervorgerufenen Magnetfeld (30) ausgesetzt ist, wobei die erste Energieversorgungsschaltung (28) angeordnet ist, um den Stromsensor (25) mindestens teilweise mittels einer Spannung (u) zu speisen, die durch das Magnetfeld (30) in die Luftkernspule (29) induziert wird.

2. Stromsensor (25) gemäß Anspruch 1, **dadurch gekennzeichnet, dass** die Luftkernspule eine Rogowski-Spule (29) ist.

3. Stromsensor (25) gemäß Anspruch 1 oder 2, **dadurch gekennzeichnet, dass** die erste Energieversorgungsschaltung (28) einen Gleichrichter (31) zum Gleichrichten der in die Luftkernspule (29) induzierten Spannung (u) aufweist und/oder die erste Energieversorgungsschaltung (28) einen Spannungsstabilisator (33) zum Stabilisieren der in die Spule induzierten Spannung (u) aufweist.

4. Stromsensor (25) gemäß einem der vorangegangenen Ansprüche, **dadurch gekennzeichnet, dass** die Energieversorgungsanordnung (27) eine zweite Energieversorgungsschaltung (37) aufweist, die an eine externe Energiequelle (65) zum Speisen des Stromsensors (25) angeschlossen werden kann.

5. Stromsensor (25) gemäß Anspruch 4, **dadurch gekennzeichnet, dass** die externe Energiequelle eine Lichtquelle (61) ist und die zweite Energieversorgungsanordnung (37) einen optischen Leistungswandler (39) zum Wandeln von Lichtstrahlung, die von der Lichtquelle (61) emittiert wird, in elektrische Leistung aufweist.

6. Stromsensor (25) gemäß einem der vorangegangenen Ansprüche, **dadurch gekennzeichnet, dass** der Stromsensor (25) einen Parallelwiderstand (47) aufweist, der so in die Hochspannungsleitung (13) eingefügt ist, dass der Strom (I) an der Hochspannungsleitung zu einem Spannungsabfall (u_{I}) am Parallelwiderstand (47) führt, wobei ein Betrag des Spannungsabfalls (u_{I}) dem Strom (I) an der Hochspannungsleitung (13) entspricht.

7. Stromsensor (25) gemäß einem der vorangegangenen Ansprüche, **dadurch gekennzeichnet, dass** der Stromsensor (25) eine Datenübertragungsanordnung zum Übertragen von Daten, die einen Wert des von der Stromsensoranordnung erfassten Stroms repräsentieren, aufweist.

8. Stromsensor (25) gemäß Anspruch 7, **dadurch gekennzeichnet, dass** die Datenübertragungsanordnung einen optischen Sender (55) zum Übertragen der Daten, die den Wert des Stroms (I) an der Hochspannungsleitung (13) repräsentieren, aufweist.

9. Strommessvorrichtung (77) für eine Hochspannungs-Gleichstromleitung (13) mit einem Stromsensor (25) und einer Datenempfängeranordnung (73), die aneinander gekoppelt sind, **dadurch gekennzeichnet, dass** der Stromsensor (25) ein Stromsensor (25) gemäß einem der vorangegangenen Ansprüche ist.

10. Strommessvorrichtung (77) gemäß Anspruch 9, **dadurch gekennzeichnet, dass** die Strommessvorrichtung (77) eine Lichtquelle (65), die vorzugsweise einen Laser (63) aufweist, besitzt, und **dadurch**, dass die Lichtquelle (65) an den optischen Leistungswandler (39) des Stromsensorelements gekoppelt ist.

11. Strommessvorrichtung (77) gemäß Anspruch 9 oder 10, **dadurch gekennzeichnet, dass** die Lichtquelle (65) der Datenempfängeranordnung (73) und der optische Leistungswandler (39) des Stromsensors (25) durch einen ersten Lichtleiter (43) gekoppelt sind und/oder ein optischer Empfänger (71) der Datenempfängeranordnung (73) und der optische Sender (55) des Stromsensors (25) durch einen zweiten Lichtleiter (59) gekoppelt sind.

12. Strommessvorrichtung (77) gemäß Anspruch 9 oder 10, **dadurch gekennzeichnet, dass** die Lichtquelle (65) der Datenempfängeranordnung (73) und der optische Leistungswandler (39) des Stromsensors (25) sowie ein optischer Empfänger (71) der Datenempfängeranordnung (73) und der optische Sender (55) des Stromsensors (25) durch einen einzigen Lichtleiter (83) gekoppelt sind.

13. Strommessvorrichtung gemäß Anspruch 11, **dadurch gekennzeichnet, dass** der erste Lichtleiter (43), der zweite Lichtleiter (59) und/oder der einzige Lichtleiter (83) eine optische Faser ist.

14. Strommessvorrichtung (77) gemäß einem der Ansprüche 10 bis 13, **dadurch gekennzeichnet, dass** die Datenempfängeranordnung (73) an die Lichtquelle (65) angeschlossen ist, um eine Ausgangsleistung der Lichtquelle (65) abhängig von der optischen Leistung, die vom optischen Leistungswandler (39) zum Betreiben des Stromsensors (25) benötigt wird, zu regeln.

## Revendications

1. Capteur de courant actif (25) pour un dispositif de mesure de courant (77) permettant de mesurer un courant (I) au niveau d'une ligne de courant continu à haute tension (13), dans lequel le capteur de courant (25) comprend un agencement d'alimentation en puissance (27) afin d'alimenter le capteur de courant (25), **caractérisé en ce que** l'agencement d'alimentation en puissance (27) comprend des premiers circuits d'alimentation en puissance (28) qui ont une bobine à noyau d'air (29) exposée à un champ magnétique (30) créé par le courant (I) au niveau de la ligne à haute tension (13), dans lequel les premiers circuits d'alimentation en puissance (28) sont agencés afin d'alimenter le capteur de courant (25) au moins partiellement, au moyen d'une tension (u) induite dans la bobine à noyau d'air (29) par le champ magnétique (30).

2. Capteur de courant (25) selon la revendication 1, **caractérisé en ce que** la bobine à noyau d'air est un enroulement de Rogovski.

3. Capteur de courant (25) selon la revendication 1 ou 2, **caractérisé en ce que** les premiers circuits d'alimentation en puissance (28) comprennent un redresseur (31) permettant de redresser la tension (u) induite dans la bobine à noyau d'air (29) et/ou les premiers circuits d'alimentation en puissance (28) comprennent un stabilisateur de tension (33) permettant de stabiliser la tension (u) induite dans la bobine.

4. Capteur de courant (25) selon l'une des revendications précédentes, **caractérisé en ce que** l'agencement d'alimentation en puissance (27) comprend des seconds circuits d'alimentation en puissance (37) qui peuvent être connectés à une source de puissance extérieure (65) pour alimenter le capteur de courant (25).

5. Capteur de courant (25) selon la revendication 4, **caractérisé en ce que** la source de puissance extérieure est une source lumineuse (61) et le second agencement d'alimentation en puissance (37) comprend un convertisseur de puissance optique (39) pour convertir la radiation lumineuse émise par la source lumineuse (61) en puissance électrique.

6. Capteur de courant (25) selon l'une des revendications précédentes, **caractérisé en ce que** le capteur de courant (25) comprend un shunt (47) inséré dans la ligne à haute tension (13), de telle sorte que le courant (I) au niveau de la ligne à haute tension mène à une chute de tension (u_{I}) au niveau du shunt (47), dans lequel une amplitude de la chute de tension (u_{I}) correspond au courant (I) au niveau de la ligne à haute tension (13).

7. Capteur de courant (25) selon l'une des revendications précédentes, **caractérisé en ce que** le capteur de courant (25) comprend un agencement de transmission de données pour la transmission de données représentant une valeur du courant acquise par l'agencement de capteur de courant.

8. Capteur de courant (25) selon la revendication 7, **caractérisé en ce que** l'agencement de transmission de données comprend un émetteur optique (55) permettant de transmettre les données représentant la valeur du courant (I) au niveau de la ligne à haute tension (13).

9. Dispositif de mesure du courant (77) la ligne de courant continu à haute tension (13) comprenant un capteur de courant (25) et un agencement du récepteur de données (73) couplés ensemble, **caractérisé en ce que** le capteur de courant (25) est un capteur de courant (25) selon l'une des revendications précédentes.

10. Dispositif de mesure du courant (77) selon la revendication 9, **caractérisé en ce que** le dispositif de mesure de courant (77) possède une source lumineuse (65), de préférence comprenant un laser (63) et **en ce que** la source lumineuse (65) est couplée au convertisseur de puissance optique (39) de l'élément capteur de courant.

11. Dispositif de mesure du courant (77) selon la revendication 9 ou 10, **caractérisé en ce que** la source de lumière (65) de l'agencement du récepteur de données (73) et le convertisseur de puissance optique (39) du capteur de courant (25) sont couplés par un premier guide d'ondes optiques (43) et/ou un récepteur optique (71) de l'agencement du récepteur de données (73) et l'émetteur optique (55) du capteur de courant (25) sont couplés par un second guide d'ondes optiques (59).

12. Dispositif de mesure du courant (77) selon la revendication 9 ou 10, **caractérisé en ce que** la source lumineuse (65) de l'agencement du récepteur de données (73) et le convertisseur de puissance optique (39) du capteur de courant (25) ainsi qu'un récepteur optique (71) de l'agencement du récepteur de données (73) et l'émetteur optique (55) du capteur de courant (25) sont couplés par un guide d'ondes optiques unique (83).

13. Dispositif de mesure du courant (77) selon la revendication 11, **caractérisé en ce que** le premier guide d'ondes optiques (43), le second guide d'ondes optiques (59), et/ou le guide d'ondes optiques unique (83) est une fibre optique.

14. Dispositif de mesure du courant (77) selon l'une des revendications 10 à 13, **caractérisé en ce que** l'agencement du récepteur de données (73) est connecté à la source lumineuse (65) afin de contrôler une puissance de sortie de la source lumineuse (65) en fonction de la puissance optique requise par le convertisseur de puissance optique (39) pour faire fonctionner le capteur de courant (25).
